# FASCICULE DE BREVET EUROPEEN

(11) **EP 1 098 355 B1**
(45) Date de publication et mention de la délivrance du brevet: **19.03.2008**
(21) Numéro de dépôt: 00410138.2
(22) Date de dépôt: 02.11.2000
(51) Int. Cl.: H01L 29/747, H01L 29/74

(54) **Détecteur d'état de composant de puissance**
Leistungsdetektor-Bauteil
Powerdetector component

(30) Priorité: 03.11.1999 FR 9914011
(43) Date de publication de la demande: 09.05.2001
(73) Titulaire: STMicroelectronics S.A., 92120 Montrouge (FR)
(72) Inventeur: Simonnet, Jean-Michel, 37270 Veretz (FR)
(74) Mandataire: de Beaumont, Michel

(56) Documents cités:
- EP-A- 0 709 891
- EP-A- 0 721 218
- EP-A- 0 817 277
- EP-A- 0 881 672
- EP-A- 0 987 751
- DE-A- 4 316 509
- FR-A- 2 773 021
- US-A- 5 036 377
- US-A- 5 889 374

## Description

La présente invention concerne la réalisation sous forme monolithique d'un détecteur d'état (passant ou bloqué) d'un composant de puissance. La présente invention s'applique en particulier à la réalisation d'un détecteur d'état d'un commutateur bidirectionnel de moyenne puissance de type ACS, qui sera décrit ci-après.

Les commutateurs bidirectionnels statiques les plus courants sont les triacs. Un triac correspond à l'association en antiparallèle de deux thyristors. Il peut donc être connecté directement dans un réseau alternatif, par exemple le secteur. La gâchette d'un triac classique correspond à la gâchette de cathode de l'un au moins des deux thyristors qui le constituent et est référencée à l'électrode située sur la face avant de ce triac, c'est-à-dire la face qui comporte la borne de gâchette, alors que c'est l'autre face du triac qui est couramment reliée à un radiateur et à la masse. Ceci complique la réalisation des circuits de commande.

Des commutateurs bidirectionnels dits ACS sont décrits par exemple dans la demande de brevet européen N° 0817277 (B3073). Le déclenchement d'un "ACS" est assuré par application d'une tension entre une électrode de commande située sur la face avant du composant et une électrode principale située sur la face arrière du composant, couramment reliée à la masse.

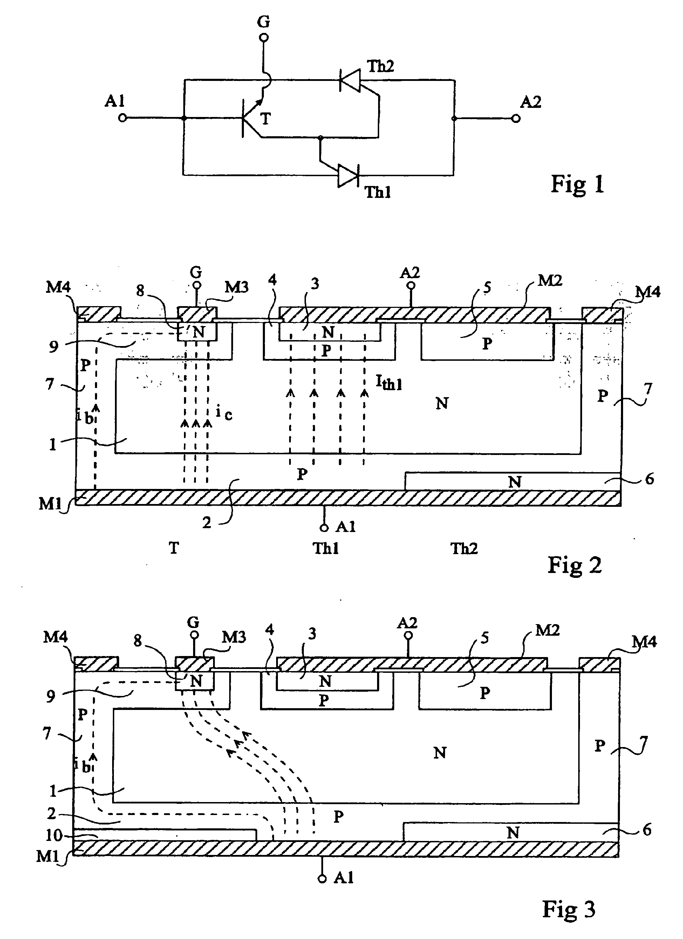

La figure 1 représente le schéma électrique équivalent d'un commutateur bidirectionnel de type ACS. Une électrode G de commande du commutateur bidirectionnel est reliée à l'émetteur d'un transistor bipolaire T dont le collecteur est relié aux gâchettes d'anode de premier et deuxième thyristors Th1 et Th2 placés en antiparallèle entre deux bornes A1 et A2. La borne A1 correspond à l'anode du thyristor Th1 et à la cathode du thyristor Th2. La borne A1 est également reliée à la base du transistor T. La borne A2 correspond à l'anode du thyristor Th2 et à la cathode du thyristor Th1.

La figure 2 est une vue en coupe schématique d'un exemple de réalisation sous forme monolithique d'un "ACS". Le transistor T est réalisé dans la partie gauche de la figure, le thyristor Th1 au centre et le thyristor Th2 à droite.

La structure de la figure 2 est formée à partir d'un substrat semiconducteur 1 faiblement dopé de type N. L'anode du thyristor Th1 correspond à une couche 2 de type P qui est formée du côté de la face arrière du substrat 1. Sa cathode correspond à une région 3 de type N formée du côté de la face avant dans un caisson 4 de type P. L'anode du thyristor Th2 correspond à un caisson 5 de type P formé du côté de la face avant et sa cathode correspond à une région 6 de type N formée du côté de la face arrière dans la couche 2. La périphérie de la structure est constituée d'un mur d'isolement 7 de type P fortement dopé s'étendant depuis la face avant jusqu'à la couche 2 de type P. De façon classique, le mur 7 est obtenu par diffusion profonde à partir des deux faces du substrat. La face arrière est revêtue d'une métallisation M1 correspondant à la première borne A1 du commutateur bidirectionnel. Les faces supérieures des régions 3 et 5 sont revêtues d'une deuxième métallisation M2 correspondant à la deuxième borne A2 du commutateur bidirectionnel. Une région 8 de type N est formée, du côté de la face avant, dans un caisson 9 de type P en contact avec la région périphérique 7. La surface de la région 8 est solidaire d'une métallisation M3 reliée à la borne de commande G du commutateur bidirectionnel. Une métallisation M4 peut être formée sur la surface supérieure de la région périphérique 7. La métallisation M4 n'est pas connectée à une borne externe. A titre de variante, le caisson 9 peut être séparé de la région périphérique 7 et relié électriquement à celle-ci par l'intermédiaire de la métallisation M4.

Le fonctionnement de ce commutateur bidirectionnel est le suivant.

Quand la borne A2 est négative par rapport à la borne A1, c'est le thyristor Th1 qui est susceptible d'être passant. Si on applique sur la borne G une tension suffisamment négative par rapport à la métallisation M1, la jonction base-émetteur du transistor T est polarisée en direct et ce transistor devient passant. Il circule donc un courant vertical i_{c} représenté en pointillés en figure 2 depuis la métallisation M1, à travers la jonction en direct entre la couche 2 et le substrat 1 puis dans les régions 1, 9 et 8 correspondant au transistor T. Il y a donc une génération de porteurs au niveau de la jonction entre le substrat 1 et le caisson 9 près de la jonction entre le substrat 1 et le caisson 4 et le thyristor Th1 est mis en état de conduction. On peut également considérer que l'on a provoqué l'amorçage d'un thyristor auxiliaire vertical NPNP comprenant les régions 8-9-1-2, dont la région 9 constitue la région de gâchette de cathode.

Quand la borne A2 est positive par rapport à la borne A1, l'application d'une tension négative sur la borne G rend passant le transistor T. Les porteurs présents au voisinage de la jonction entre le substrat 1 et la couche 5 entraînent la mise en conduction du thyristor Th2.

Diverses variantes de réalisation d'un commutateur ACS sont décrites dans les demandes de brevet français 99/10412 et 99/10413 (B4341, B4342) déposées le 9 août 1999 par la demanderesse. Par exemple, comme cela est représenté en figure 3, une région 10 de type N est ajoutée pour améliorer la sensibilité de commande.

Un objet de la présente invention est de proposer un mode de réalisation sous forme monolithique d'un composant de puissance associé à un détecteur d'état (passant ou bloqué).

Un objet de la présente invention est de proposer un tel détecteur d'état associé à un commutateur ACS.

Pour atteindre ces objets, la présente invention prévoit un dispositif comprenant un détecteur d'état (passant ou bloqué) d'un composant de puissance vertical formé dans un substrat semiconducteur faiblement dopé d'un premier type de conductivité ayant une face avant et une face arrière, dans lequel la région correspondant au composant de puissance est entourée d'un mur d'isolement de type opposé à celui du substrat. Ce détecteur d'état est formé à l'extérieur de ladite région et est constitué d'un composant de détection vertical dont l'état est commuté par des charges parasites se propageant à l'extérieur du mur d'isolement quand le composant de puissance est passant.

Selon un mode de réalisation de la présente invention, le détecteur d'état est constitué d'un transistor vertical dont le substrat forme la base.

Selon un mode de réalisation de la présente invention, le transistor vertical comprend, du côté de la face inférieure une région à diffusion profonde formée en même temps que la diffusion de mur d'isolement de face inférieure.

Selon un mode de réalisation de la présente invention, le détecteur d'état comprend plusieurs transistors verticaux, distincts dont les régions d'émetteur, formées du côté de la face inférieure de substrat, ont des profondeurs de diffusion distinctes.

Selon un mode de réalisation de la présente invention, la face arrière de la structure semiconductrice comprenant le composant de puissance et le composant de détection est revêtue d'une métallisation connectée à un potentiel de référence.

Selon un mode de réalisation de la présente invention, une métallisation de face avant du composant de détection est liée à un potentiel fixe par rapport au potentiel de référence.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est un schéma électrique d'un commutateur bidirectionnel de type ACS ;
la figure 2 est une vue en coupe schématique d'un mode de réalisation du commutateur de la figure 1 ;
la figure 3 est une vue en coupe schématique d'une variante de réalisation du commutateur de la figure 1 ;
la figure 4 représente sous forme très schématique la structure d'ensemble d'un détecteur selon la présente invention ;
la figure 5 représente un mode de réalisation de la présente invention adapté à la détection de l'état passant ou bloqué d'un commutateur ACS ; et
les figures 6 et 7 représentent des vues partielles du schéma de la figure 5 destinées à expliquer le fonctionnement d'un mode de réalisation particulier de la présente invention.

Dans les diverses figures, de mêmes références désignent des éléments similaires ou identiques. De plus, conformément à l'usage dans le domaine de la représentation des composants semiconducteurs, les figures 2-7 ne sont pas à l'échelle.

De façon générale, dans le domaine des composants de puissance, la connaissance de l'état passant ou bloqué d'un commutateur de puissance est primordiale. On peut alors commander des composants extérieurs ou interdire leur fonctionnement. Une telle détection est par exemple utile pour s'apercevoir d'une mise en conduction accidentelle d'un composant de puissance liée à des signaux parasites, ou encore dans le cas où un composant de puissance est dégradé et reste à l'état passant alors qu'il a été commandé à l'état bloqué. Cette détection pourra aussi être utilisée pour détecter la commutation d'un composant de protection dans le but de déclencher une protection complémentaire, par exemple un commutateur série, ou dans le but d'effectuer une analyse d'incidents.

De façon usuelle, pour effectuer une telle détection, on insère une résistance de faible valeur et de forte tenue en courant dans le circuit série du composant de puissance. La différence de potentiel aux bornes de cette résistance indique l'état passant ou bloqué du commutateur. Cette résistance, soumise à des contraintes importantes, est chère, peut être volumineuse, et est généralement réalisée sous forme d'un composant discret externe au circuit intégré de puissance incorporant le composant de puissance.

La présente invention tire profit d'une constatation réalisée par la demanderesse et décrite dans la demande de brevet européen 0881672 (B3484) correspondant au préambule de la revendication 1 selon laquelle, quand un composant de puissance est entouré d'un mur d'isolement, si on utilise un mur d'isolement réalisé de façon classique tel que la concentration d'atomes dopants dans la zone médiane du mur d'isolement est relativement faible, on assure un isolement statique entre composants voisins mais pas un isolement dynamique. Ainsi des porteurs de charge générés dans la zone du composant de puissance entourée d'un mur d'isolement lors du passage d'un courant élevé dans celui-ci se répandent dans les zones voisines en dépit de l'existence de ce mur d'isolement quand un courant important traverse le composant de puissance.

Dans l'art antérieur et dans la demande de brevet susmentionnée, cette "perméabilité" des murs d'isolement a toujours été considérée comme un inconvénient.

La présente invention vise à tirer profit de ce défaut en disposant, à l'extérieur d'un mur d'isolement entourant un composant de puissance de type vertical un composant vertical de détection, susceptible d'être mis en conduction par les porteurs parasites produits à l'extérieur du mur d'isolement par la mise en conduction du composant de puissance. Ce composant de détection est mis à l'état passant ou à l'état bloqué en fonction de l'état du composant principal et l'état du composant de détection révèle l'état du composant principal.

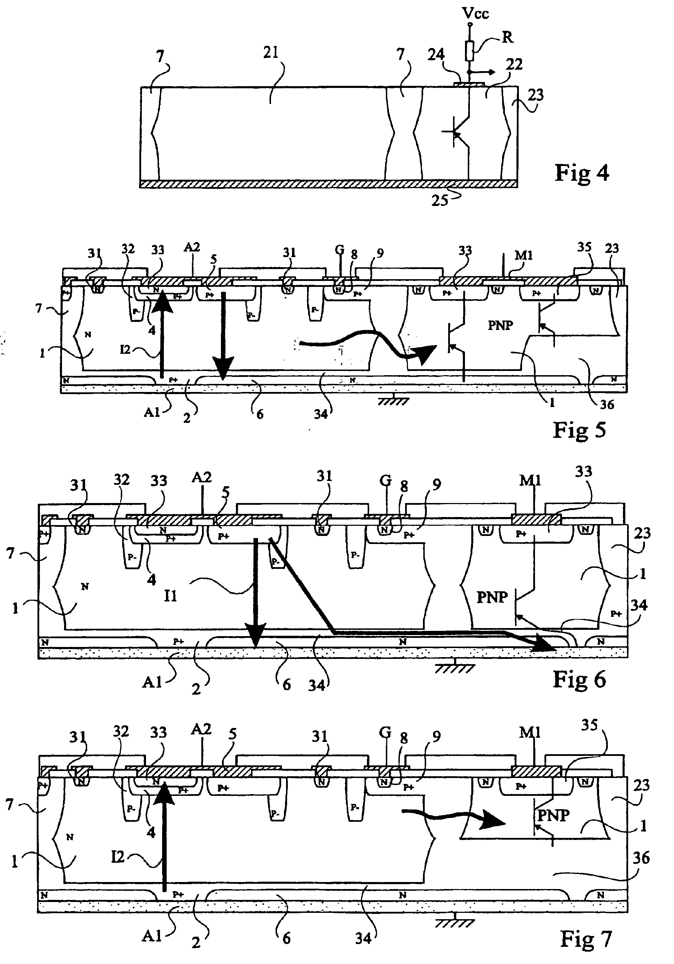

Cet aspect général de la présente invention est illustré en figure 4 qui représente une portion d'une plaquette semiconductrice comprenant un substrat faiblement dopé. Un mur d'isolement 7 délimite une partie 21 du substrat dans laquelle sont formées, à partir des faces inférieures et supérieures diverses couches (non représentées) destinées à constituer un composant de puissance. Comme cela est décrit dans la demande de brevet européen susmentionnée, quand le composant de puissance est traversé par un courant relativement important, un mur d'isolement 7 classique est traversé par des porteurs de charge qui diffusent dans une zone 22 du substrat externe au mur 7 et de préférence elle-même délimitée par un mur d'isolement 23. Comme cela est représenté, cette zone 22 comprend par exemple un composant vertical dont une première borne est liée à une métallisation 24 de face avant et dont une deuxième borne est liée à une métallisation 25 de face arrière. Ce composant, comme on le verra ci-après, est par exemple du type transistor et la génération de porteurs dans la région correspondant à sa base le met en conduction. Si une tension est appliquée entre les bornes 24 et 25, cette mise en conduction peut être détectée par tout moyen classique. Par exemple, la métallisation 24 est reliée à une source d'alimentation basse tension VCC par l'intermédiaire d'une résistance de forte valeur R. Ainsi, quand le transistor est bloqué, la métallisation 24 est sensiblement au potentiel VCC, tandis que, quand le transistor est passant, la métallisation 24 est sensiblement à la masse (potentiel de la face arrière du composant de puissance).

La figure 5 représente à titre d'exemple une application de la présente invention à la détection de la mise en conduction d'un composant de type ACS tel que décrit précédemment. Dans cette figure 5, on utilisera des références analogues à celles de la figure 3 pour désigner des régions ou couches similaires.

Le composant de puissance est formé dans un substrat 1 délimité par un mur d'isolement 7. Entre une métallisation d'électrode principale A2 disposée du côté de la face supérieure et une métallisation de face inférieure sont disposés un premier thyristor comportant des régions 3 et 4, le substrat 1 et une région P⁺ 2, et un deuxième thyristor comportant une région de type P 5, le substrat 1, la région P⁺ 2 et une région N⁺ 6. Une électrode de déclenchement G est solidaire d'une région 8 de type N⁺ reliée par une région 9 de type P au mur d'isolement 7. On a également représenté des régions d'arrêt de canal 31 disposées du côté de la face supérieure ainsi que des régions 32 de type P faiblement dopées et à diffusion profonde disposées à la périphérie externe des régions de type P de face supérieure 4, 5 et 9 afin d'améliorer la tenue en tension du composant.

A l'extérieur du mur d'isolement 7 est disposé un composant de détection constitué dans la figure 5 de l'association en parallèle de deux transistors verticaux PNP entre une métallisation de face supérieure M10 et la métallisation de face inférieure A1. Le premier transistor PNP de type vertical comprend une région de type P 33, le substrat 1 et une extension 34 de la région de type P 2 décrite précédemment. Bien que cela n'apparaisse dans la vue en coupe de la figure 5, une partie de la région de type P 34 est en contact avec l'électrode de face inférieure A1. Le deuxième transistor PNP comprend une région de type P 35, le substrat 1 et une région profonde de type P 36 formée en même temps que les murs d'isolement de face inférieure.

Les figures 6 et 7 représentent des portions du circuit de la figure 5.

La figure 6 concerne le cas où l'électrode principale de face supérieure A2 est positive par rapport à l'électrode de face inférieure A1. Dans ce cas, un courant Il circule dans le thyristor comprenant les régions 5-1-2-6. Toutefois, tout le courant Il ne s'écoule pas vers la région 1 mais une partie de ce courant se prolonge vers l'extérieur du mur d'isolement en passant par la région de type P 6 vers la région de type P 34 et entraînant la diffusion de porteurs dans la partie du substrat 1 disposée à l'extérieur du mur d'isolement 7. Si une tension positive ou négative est appliquée sur la métallisation M10 du transistor de détection, ce transistor de détection devient alors passant et cet état passant peut être détecté.

La figure 7 illustre le cas où l'électrode A1 de face inférieure est positive par rapport à l'électrode A2 de face supérieure. En ce cas, un courant I2 circule de la façon représentée dans le thyristor 2-1-4-3. Alors, conformément à ce qui a été exposé dans la demande de brevet européen susmentionnée, des charges traversent le mur d'isolement et pénètrent à l'extérieur de celui-ci dans la région correspondant à la base du transistor PNP 35-1-36.

Il a été montré par des études expérimentales et des simulations que les structures de transistors PNP respectivement illustrées en figures 6 et 7 sont mieux adaptées à être déclenchées dans chacun des cas considérés.

Bien entendu la présente invention est susceptible de nombreuses variantes et modifications.

Notamment, le transistor de détection selon la présente invention pourra être remplacé par un autre élément susceptible d'être déclenché quand un courant passe dans un caisson contenant une structure de puissance principale.

D'autre part, bien que l'on ait décrit en détail en relation avec les figures 5, 6 et 7 le cas où la structure principale est un composant de type ACS, la présente invention s'applique à la détection du passage de courant dans tout autre composant de puissance principal, par exemple une simple diode, un composant de protection mono- ou bidirectionnel, un transistor de puissance, ou autre.

## Revendications

1. Dispositif semiconducteur comprenant un composant de puissance vertical formé dans un substrat semiconducteur (1) faiblement dopé d'un premier type de conductivité ayant une face avant et une face arrière, dans lequel la région correspondant au composant de puissance est entourée d'un mur d'isolement (7) de type opposé à celui du substrat, **caractérisé en ce qu'**un détecteur d'état passant ou bloqué est formé à l'extérieur de ladite région et **en ce qu'**il est constitué d'un composant de détection vertical dont l'état est commuté par des charges parasites se propageant à l'extérieur du mur d'isolement (7) quand le composant de puissance est passant.

2. Dispositif selon la revendication 1, **caractérisé en ce qu'**il est constitué d'un transistor vertical dont le substrat forme la base.

3. Dispositif selon la revendication 1, **caractérisé en ce que** ledit transistor vertical comprend, du côté de la face inférieure une région à diffusion profonde formée en même temps que la diffusion de mur d'isolement de face inférieure.

4. Dispositif selon la revendication 2, **caractérisé en ce qu'**il comprend plusieurs transistors verticaux, distincts dont les régions d'émetteur, formées du côté de la face inférieure de substrat ont des profondeurs de diffusion distinctes.

5. Dispositif selon l'une quelconque des revendications 1 à 4, **caractérisé en ce que** la face arrière de la structure semiconductrice comprenant le composant de puissance et le composant de détection est revêtue d'une métallisation connectée à un potentiel de référence.

6. Dispositif selon la revendication 5, **caractérisé en ce qu'**une métallisation de face avant du composant de détection est liée à un potentiel fixe par rapport au potentiel de référence.

## Claims

1. A semiconductor device comprising a detector of the on or off state of a vertical power component formed in a lightly-doped semiconductor substrate (1) of a first conductivity type having a front surface and a rear surface, in which the region corresponding to the power component is surrounded with an isolating wall (7) of opposite conductivity type to that of the substrate, **characterized in that** a device formed outside of said region and being formed with a vertical detection component, the state of which is switched by parasitic charges propagating outside of the isolating wall (7) when the power component is on.

2. The device of claim 1, formed of a vertical transistor, the substrate of which forms the base.

3. The device of claim 1, wherein the vertical transistor includes, on its lower surface side, a deep diffused region formed at the same time as the diffusion of the lower surface isolating wall.

4. The device of claim 2, including several distinct vertical transistors, the emitter regions of which, formed on the lower surface side of the substrate, have distinct diffusion depths.

5. The device of any of claims 1 to 4, wherein the rear surface of the semiconductive layer including the power component and the detection component is coated with a metallization connected to a reference potential.

6. The device of claim 5, wherein a front surface metallization of the detection component is connected to a voltage which is fixed with respect to the reference voltage.

## Patentansprüche

1. Ein Halbleiterbauelement, das Folgendes aufweist:
einen Detektor für den Ein- oder Aus-Zustand einer vertikalen Leistungskomponente, die in einem leicht dotierten Halbleitersubstrat (1) eines ersten Leitfähigkeitstyps mit einer Vorderseite und einer Rückseite ausgebildet ist, wobei der Bereich, der der Leistungskomponente entspricht mit einer Isolierwand (7) des entgegengesetzten Leitfähigkeitstyps zu dem des Substrats umgeben ist, **dadurch gekennzeichnet, dass** ein Bauelement außerhalb des Bereichs ausgebildet ist und mit einer vertikalen Detektierkomponente versehen ist, deren Zustand durch parasitische Ladungen, die sich außerhalb der Isolierwand (7) fortpflanzen, geschaltet wird, wenn die Leistungskomponente an ist

2. Bauelement nach Anspruch 1, das aus einem Vertikaltransistor gebildet ist, dessen Substrat die Basis bildet.

3. Bauelement nach Anspruch 1, wobei der Vertikaltransistor an seiner Unterseite einen tief diffundierten Bereich umfasst, der zur selben Zeit ausgebildet wird, wie die Diffusion der Unterseitenisolierwand.

4. Bauelement nach Anspruch 2, das mehrere getrennte vertikale Transistoren umfasst, deren Emitterbereiche an der Unterseite des Substrats mit unterschiedlichen Diffusionstiefen ausgebildet sind

5. Bauelement nach einem der Ansprüche 1 bis 4, wobei die Rückseite der Halbleiterschicht, welche die Leistungskomponente und die Detektierkomponente umfasst mit einer Metallisierung beschichtet ist, die mit einem Bezugispotential verbunden ist.

6. Bauelement nach Anspruch 5, wobei eine Vorderseitenmetallisierung der Detektierkomponente mit einer Spannung verbunden ist, die bezuglich der Bezugsspannung festgelegt ist.
